# EUROPÄISCHE PATENTANMELDUNG

(11) **EP 1 289 147 A1**
(43) Veröffentlichungstag der Anmeldung: **05.03.2003**
(21) Anmeldenummer: 01440262.2
(22) Anmeldetag: 13.08.2001
(51) Int. Cl.: H03K 17/95

(54) **Fremderregte Näherungs-oder Anwesenheitsschalteranordnung**

(71) Anmelder: SENSTRONIC, S.A., F-67700 Saverne (FR)
(72) Erfinder: Schmidt, Ralf, 67251 Freinsheim (DE)
(74) Vertreter: Nuss, Pierre

(57) **Zusammenfassung**

Die Erfindung betrifft eine nach dem induktiven Wirkprinzip arbeitende Näherungs- oder Anwesenheitsschalteranordnung, welche wenigstens eine in einem Schwingkreis integrierte Induktivität und eine nachgeschaltete elektronische Steuer -bzw. Bewertungsvorrichtung beinhaltet, zur Fühlung oder Ermittlung der Annäherung und/ oder Anwesenheit eines elektromagnetische Felder beeinflussenden Materials.

Diese Anordnung ist dadurch gekennzeichnet, daß der Schwingkreis in vorgegebenen Zeitabständen erregt wird um eine fremderregte vorzugsweise über mehrere Perioden abklingende Schwingung zu erzeugen, wobei das Erregungssignal eine Frequenz besitzt die gleich oder verschieden von der Eigenschwingungsfrequenz des Schwingkreises ist, und, daß die elektronische Vorrichtung (3) die Änderung(en) eines oder mehrerer Parameter(s)(n) wie z. B. Frequenz, Amplitude und/ oder Phase des erzeugten Schwingungssignals, gegebenenfalls komparativ gegenüber mindestens einer Referenzschwingung oder Referenzwerten, ermittelt und bewertet, und (eine) entsprechende Aktion(en) auslöst oder veranlasst falls die Bewertungsresultate vorgegebene Schwellenwerte überschreiten.

## Beschreibung

Die vorliegende Erfingdung betrifft das Gebiet der Erfassung und des Fühlens mittels elektronischer Sensoren oder Detektoren, insbesondere metallischer Gegenstände, und betrifft eine nach dem induktiven Wirkprinzip arbeitende Näherungs- oder Anwesenheitsschalteranordnung.

Solche Schalteranordnungen werden hauptsächlich im Zusammenhang mit automatisierten Arbeitsvorrichtungen (wie z. B. Robotern) oder mit Sicherheitsvorrichtungen verwendet, insbesondere in der Automobilindustrie.

Die in diesen Schaltanordnungen vorhandenen Induktivitäten werden mit einem schwingenden elektrischen Signal gespeist und entwickeln somit ein Wechselhaftes magnetisches Fühlerfeld, dessen Beschaffenheit von der Beschaffenheit der Induktivität und den Merkmalen des gespeisten Signals abhängt.

Wenn nun ein metallischer Gegenstand in den Bereich dieses Feldes eintritt, wird letzteres geändert durch die bedämpfende Wirkung dieses Gegenstandes. Diese Änderung wird dann erfasst und bewertet, um gegebenenfalls Aktionen einzuleiten wenn vorbestimmte Bedingungen eintreten bzw. überschritten werden, wie z. B. Schaltzustandsänderungen angeschloßener Schaltverstärker.

Werden diese Schalteranordnungen in einer industriellen Umgebung eingesetzt, kommt es vor, daß sie meß - bzw. fühlstörenden Einflüßen ausgesetzt werden, wie z. B. metalstaub oder Schweizpartikel die sich auf dem Gehäuse ansammeln können.

Es ist schon eine Schalteranordnung vom eingangsgennanten Typ bekannt, bei der versucht wird, die meßstörenden Einflüße durch eine zusätzliche Anordnung zu kompensieren.

Jedoch kommt es hierbei zu einer komplexen Struktur, in der die kompensierende Komponente selbst störenden Einflüßen ausgesetzt ist und somit nicht immer optimal ausgleichen kann.

Zudem muß noch erwähnt werden, daß bei allen existierenden vorgenannten Anordnungen eine ständige Energiezufuhr nötig ist und die Erregungssignale auf die Eigenschwingungsfrequenz des die Induktivität beinhaltenden Schwingkreises abgestimmt sind.

Es ist eine Aufgabe, der Erfindung zumindest einige der vorgenannten Nachtreile zu beheben.

Somit betrifft die Erfindung hauptsächlich eine nach dem induktiven Wirkprinzip arbeitende Näherungs- oder Anwesenhaitsschalteranordnung, welche wenigstens eine elektronische Steuer -bzw. Bewertungsvorrichtung beinhaltet, zur Fühlung oder Ermittlung der Annäherung und/ oder Anwesenheit eines elektromagnetische Felder beeinflussenden Materials, dadurch gekennzeichnet, daß der Schwingkreis in vorgegebenen Zeitabständen erregt wird, um eine fremderregte vorzugsweise periodische Schwingung zu erzeugen, wobei das Erregungssignal eine Frequenz besitzt, die gleich oder verschieden von der Eigenschwingungsfrequenz des Schwingkreises ist, und, daß die elektronische Vorrichtung die Änderung(en) eines oder mehrerer Parmeter(s)(n) wie z. B. Frequenz, Amplitude und/ oder Phase des erzeugten Schwingungssignals, gegebenenfalls komparativ gegenüber mindestens einer Referenzschwingung oder Referenzwerten, ermittelt und bewertet, und (eine) entsprechende Aktion(en) auslöst oder veranlasst falls die Bewertungsresultate vorgegebene Schwellenwerte überschreiten.

Vorzugsweise ist das erzeugte periodische fremderregte Schwingungssignal eine zumindest leichte, zeitlich abklingende Amplitude besitzt, wobei die Periode des Impulssignals mindestens fünfmal, vorzugsweise mindestens zehnmal größer als die Periode der erzeugten Schwingung ist.

Durch die Erregung mit solche zeitlich zueinander entfernten Impulse kann die Energiezufuhr, gegenüber einer konstanten Erregung, drastig gesenkt werden.

Um die Empfindlichkeit und die Reichweite der Schaltanordnung zu optimieren, ist die Induktivität auf oder unmittelbar vor oder hinter der aktiven Fläche der Schalteranordnung angebracht ist, wobei letztere Anordnung in einem Schutz- und Strukturgehäuse untergebracht ist, gegebenenfalls zusammen mit der Steuer- und Bewertungsvorrichtung.

Zumindest die aktive Fläche 4 dieses Gehäuse besteht vorzugsweise aus einem magnetische Felder nicht beeinflußenden Materials, oder aus Edelstahl.

Insbesondere kann die von der elektronischen Steuer- und Bewertungsvorrichtung ausgelöste(n) Aktion(en) das Umschalten eines wirkverbundenen Schaltverstärkers beinhalten.

Jedoch kann die ausgelöste Aktion auch der Sendung eines Warnsignals entsprechen, das von einer entfernten Verarbeitungseinheit ausgewertet wird, die dann entsprechede Maßnahmen ergreift.

Vorzugsweise, beinhaltet die elektronische Vorrichtung Mittel zum Abatsten des periodischen fremderregten Schwingungssignals, sowie gegebenenfalls Mittel zur digitalen Filterung des so abgetasteten Signals.

Im Einklang mit einem ersten Ausführungsbeispiel der Erfindung kann vorgesehen werden, daß die Änderung(en) des oder der Parameter(s)(n) durch Vergleich mit gespeicherten Referenzwerten bewertet wird (werden), aufgrund der Werte der Parameter der n-ten Schwingung jeder Signalsequenz des erzeugten periodischen fremderregten Schwingungssignals.

Die gespeicherten Referenzwerte können in einer früheren Parametrierphase erstellt werden, in identischen Erregungsbedingungen und in Abwesenheit jeglicher elektromagnetischer Beeinflüßung.

Es wird somit ein konstanter imaginärer Schwingkreis zur Verfügung gestellt.

Im Einklang mit einem zweiten Ausführungsbeispiel der Erfindung kann vorgesehen werden, daß die Schalteranordnung mindestens einen zweiten Schwingkreis beinhaltet, welchem in identischer Weise das Erregungssignal zugeführt wird, der aber gegen den Einfluß eines elektromagnetische Felder beinflussenden Materials total oder zumindest teilweise abgeschirmt ist, wobei die Bewertung der Änderung(en) mindestens eines Parameters des vom ersten Schwingkreis erzeugten periodischen fremderregten Schwingungssignals, durch Vergleich mit mindestens einem identischen Parameter des vom mindestens zweiten Schwingkreises erzeugten periodischen fremderregten Schwingungssignals, nach Abtasten und gegebenenfalls digitaler Filterung, vorgenommen wird.

Die verwendeten Induktivitäten können gleichgültig aus Luftspulen oder Spulen mit Schalenkernen (z. B. Carbonyleisen) bestehen.

Gemäß einem vorteilhaften Merkmal der Erfindung sind die Komponenten und Betriebsmerkmale der ersten und zweiten Schwingkreise gleich.

Jedoch können die Beschaffenheiten der verschiedenen Schwingkreise auch unterschiedlich sein, wobei diese Unterschiede in der Vergleichs- und Bewertungsphase in Kauf genommen werden.

In Abhängigkeit von den gewünschten Eigenschaften der Schalteranordnung, können die Induktivitäten der beiden Schwingkreise völlig voneinander entkoppelt oder in einem vorbestimmten Maße miteinander gekoppelt sein.

Das Verhältnis der Beeinflussung kann zum Teil auf beide Schwingkreise durch die Einbaugeometrie eingestellt werden.

Somit sind die felddämpfenden und auch die frequenzverschiebenden Eigenschaften ferromagnetischer Stoffe sehr empfindlich auswertbar, jedoch unerwünschte Effekte wie z. B. Temperatureinflüße werden eliminiert. Durch die Fremderregung wird eine Abtastung vorgenommen, damit entsprechend der geforderten Schaltfrequenz des wirkverbundenen Schaltverstärkers und in Relation zur Frequenz der benutzten Erregerschwingung, eine digitale Filtertiefe eingestellt werden kann, so daß eine extrem hohe Störsicherheit erreicht wird.

Gemäß einer vorteilhaften Ausgestaltung der Erfindung sind die Induktivitäten der ersten und zweiten Schwingkreise hintereinander im Gehäuse, gegenüber der aktiven Fläche desselben, angeordnet. Ferner kann zumindest eine Trennwand als elektromagnetischer Schirm zwischen den beiden Induktivitäten vorgesehen werden.

Zur digitalen Verarbeitung durch die nachgeschaltete elektronische Vorrichtung, wird vorgesehen, daß der Vergleich mindestens eines Parameters der beiden erzeugten periodischen fremderregten Schwingungssignale auf der Basis von abgetasteten Werten vorgenommen wird, wobei die Abtastung mit dem oder auf das Erregungssignal synchronisiert ist.

Die Erfindung wird nun an Hand Ausführungsbeispielen näher erläutert, dies im Zusammenhang mit den anliegenden Figuren.

Es zeigt :
Fig. 1 : eine erfinderische Schalteranordnung im Längschnitt;
Fig. 2 : Zeitdiagramme, welche jeweils das Erregungssignal (Ue), das vom ersten Schwingkreis erzeugte Signal (U1) und das vom zweiten Schwingkreis erzeugte Signal (Referenzsignal U2) darstellen;
Fig. 3 : ein elektrisches Betriebsdiagramm der auf Figur 1 teilwseise dargestellten Schwingkreise, und,
Fig. 4 : eine Seitenansicht eines Längsschnitts einer erfinderischen Schalteranordnung gemäß einem anderen Ausführungsbeispiels.

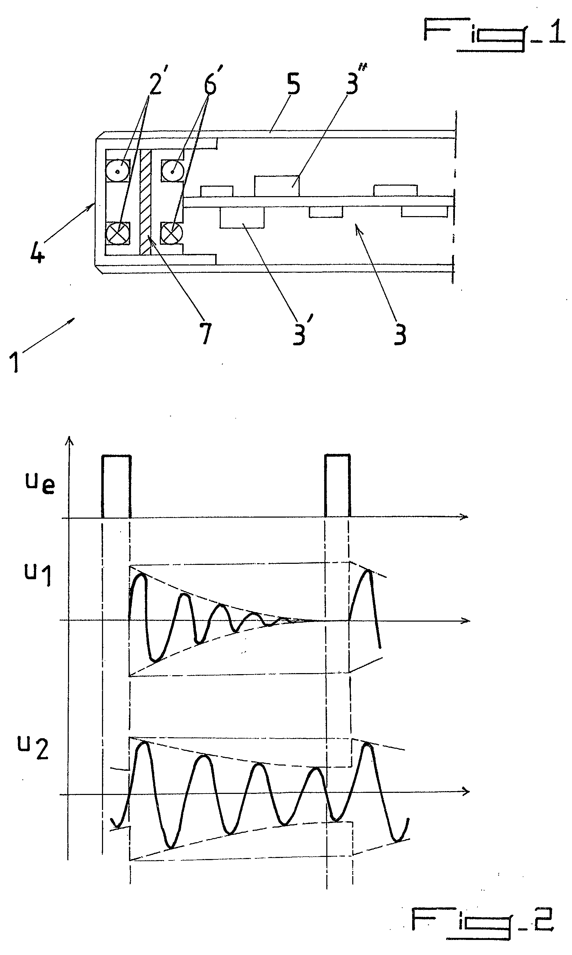

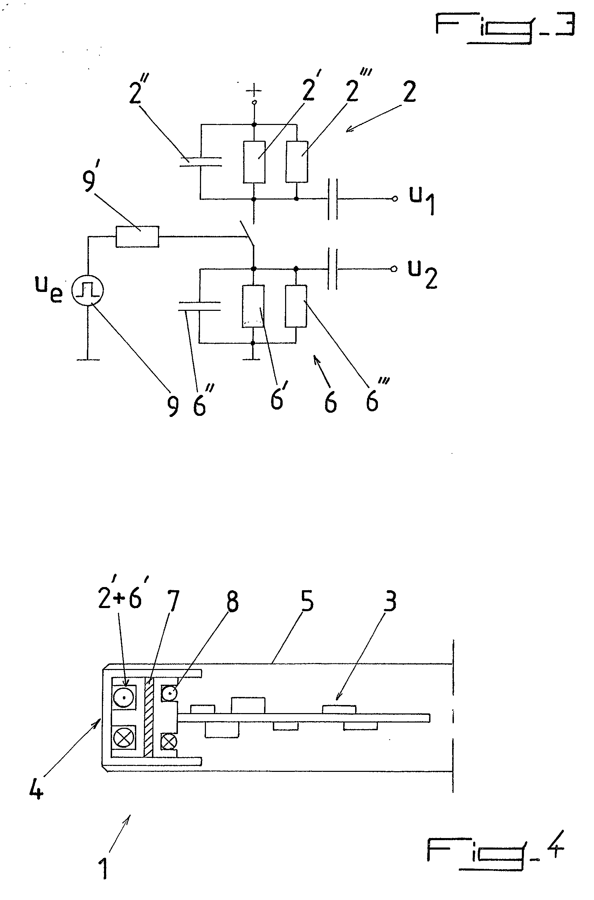

Wie in den Figuren 2 und 3 gezeigt, erzeugt ein Impulsgenerator 9 periodisch einen Impuls, - die Impulsform spielt dabei eine untergeordnete Rolle - der über ein und dieselbe Treiberstufe 9' die beiden Schwingkreise 2 und 6 (Spulensysteme) erregt.

Versehen mit je einer Induktivität 2', 6', einer Schwingkreiskapazität 2" und eines Wiederstands 2''', 6''', Schwingen nach dem Abschalten der Erregung - am Ende des Impulses - beide Schwingkreise 2 und 6 nun entkoppelt voneinander, mit einer mehr oder weniger abklingenden Amplitude.

Ob und wieweit die Amplitude zwischen zwei Erregerimpulsen abnimmt, bleibt der Philosophie des Entwicklers überlassen oder hängt von der spezifischen Anwendung ab. Bis zu einer nahezu konstanten Amplitude bleibt das Wirkprinzip der Erfindung erhalten.

Ab diesem Zeitpunkt jedoch, gehen die beiden Schwingkreissysteme 2 und 6 in eine Stabilität über, die durch die Annäherung eines äußeren, das elektromagnetische Feld beeinflussenden Gegenstands, erst sozusagen aufgebraucht werden muß.

Die Schalteranordnung 1 wird dementsprechend unempfindlicher, so daß dann nur geringere Schaltabstände erzielt werden können.

Die beiden Spulen 2' und 6' der Schwingkreise 2 und 6 sind geometrisch hintereinander angeordnet und mit einer mehr oder weniger starken Entkopplungsschicht 7 getrennt. Die Trennung der beiden Induktivitäten 2' und 6' erfolgt aus dem Grund, daß nur die zur Apertur positionierte Induktivität 2' von einem sich annähernden metallischen Gegenstand ( Bedämpfungselement "BE" ) beeinflußt werden kann.

Die Induktivitäten müssen nicht absolut entkoppelt sein, sondern können mehr oder weniger auch gewollt gekoppelt werden, um besondere Eigenschaften der Schaltanordnung 1 zu realisieren.

Dadurch nimmt aber ebenfalls die Empfindlichkeit ab, mit den gleichen Folgen.

Ein System mit abklingender Amplitude zwischen den Erregerimpulsen und vollständig entkoppelten Induktivitäten beschreibt die höchste zu erreichende Empfindlichkeit und damit auch den größten Schaltabstand.

Völlig gekoppelte Induktivitäten führen dann demzufolge zur absoluten Unempfindlichkeit, weil eine Korrelation zur Auswertung dient.

Auch Erweiterungen der Anordnung 1 durch eine oder mehrere, zusätzliche Induktivitäten 8 zur Erreichung spezieller Eigenschaften sind denkbar ( z. B. Temperaturkompensation ) und beeinflussen das Wirkprinzip nicht (siehe Fig. 4).

Ein Bedampfungselement beeinflusst die Schwingung der Aperturinduktivität - hier 2 gegenüber der mehr oder weniger entkoppelten Induktivität 6 - in folgenden Parametern :
1. Abklingzeitkonstante T / Dämpfung A
2. Frequenz f
3. maximale Amplitude
4. Phase

Abhängig vom Material des BE überwiegt der oder andere Einfluß auf die abklingende Schwingung.

Auch kann es zu einer Verstärkung, mit einer Vergrößerung der Amplituden und größerer Abklingzeitkonstanten, kommen.

Durch die Differenzbildung wird die Empfindlichkeit stark verbessert, so daß sehr große Reichweiten erzielt werden können.

Es ist möglich, die Differenz von den originalen Schwingungen oder nur von der Hüllkurve zu bilden.

Ein weiteres Merkmal dieses Wirkprinzips besteht darin, daß nach jedem Erregerimpuls eine Abtastung vorgenommen werden kann, zu dessen Zeitpunkt das Differenzsignal abgefragt wird.

Diese seit langem bekannte Technik (jedoch nicht im Zusammenhang mit induktiven Sensoren) erlaubt große Filtertiefen, so daß eine Synchronisation eingeführt wird, die jede Störung, die im allgemeinen asynchron eintritt, eliminiert.

Gerade im Schweißbereich mit sehr starken Störfeldern, die fast jedes Kernmaterial zur Sättigung bringen, ist dies ein wirksamer Schutz. Selbst bei Luftspulen dringen dank der Erfindung Störungen nicht mehr bis zur Entscheidungsschwelle (BE ja oder nein) durch.

Selbstverständlich ist die Erfindung nicht auf die beschriebenen und dargestellten Ausführungsformen begrenzt. Änderungen, z. B. in den Ausführungformen der verschiedenen Bestandteile oder Ersetzungen durch technische Äquivalente sind, soweit sie im Rahmen des beanspruchten Schutzbegehrens bleiben, jederzeit möglich.

## Patentansprüche

1. Eine nach dem induktiven Wirkprinzip arbeitende Näherungs- oder Anwesenheitsschalteranordnung, welche wenigstens eine in einem Schwingkreis integrierte Induktivität und eine nachgeschaltete elektronische Steuer -bzw. Bewertungsvorrichtung beinhaltet, zur Fühlung oder Ermittlung der Annäherung und/ oder Anwesenheit eines elektromagnetische Felder beeinflussenden Materials, **dadurch gekennzeichnet, daß** der Schwingkreis (2) in vorgegebenen Zeitabständen erregt wird um eine fremderregte vorzugsweise periodische Schwingung zu erzeugen, wobei das Erregungssignal eine Frequenz besitzt die gleich oder verschieden von der Eigenschwingungsfrequenz des Schwingkreises (2) ist, und, daß die elektronische Vorrichtung (3) die Änderung(en) eines oder mehrerer Parameter(s)(n) wie z. B. Frequenz, Amplitude und/ oder Phase des erzeugten Schwingungssignals, gegebenenfalls komparativ oder korrelativ gegenüber mindestens einer Referenzschwingung oder Referenzwerten, ermittelt und bewertet, und (eine) entsprechende Aktion(en) auslöst oder veranlasst falls die Bewertungsresultate vorgegebene Schwellenwerte überschreiten.

2. Näherungs- oder Anwesenheitsschalteranordnung gemäß Anspruch 1, **dadurch gekennzeichnet, daß** das Erregungssignal ein periodisches Impulssignal ist und, daß das erzeugte fremderregte Schwingungssignal eine zumindest leichte, zeitlich abklingende Amplitude besitzt, wobei die Periode des Impulssignals mindestens fünfmal größer als die Periode der erzeugten Schwingung ist.

3. Näherungs- oder Anwesenheitsschalteranordnung gemäß Anspruch 1 oder 2, **dadurch gekennzeichnet, daß** die Induktivität (2') auf oder unmittelbar hinter der aktiven Fläche (4) der Schalteranordnung (1)angebracht ist, wobei letztere Anordnung (1) in einem Schutz- und Strukturgehäuse (5) untergebracht ist, gegebenenfalls zusammen mit der Steuer- und Bewertungsvorrichtung (3).

4. Näherungs- oder Anwesenheitsschalteranordnung gemäß einem der Ansprüche 1 bis 3, **dadurch gekennzeichnet, daß** die von der elektronischen Steuer- und Bewertungsvorrichtung (3) ausgelöste(n) Aktion(en) insbesondere das Umschalten eines wirkverbundenen Schaltverstärkers beinhalten.

5. Näherungs- oder Anwesenheitsschalteranordnung gemäß einem der Ansprüche 1 bis 4, **dadurch gekennzeichnet, daß** die elektronische Vorrichtung (3) Mittel (3') zum Abtasten des periodischen fremderregten Schwingungssignals, sowie gegebenenfalls Mittel (3") zur digitalen Filterung des so abgetasteten Signals, beinhaltet.

6. Näherungs- oder Anwesenheitsschalteranordnung gemäß einem der Ansprüche 1 bis 5, **dadurch gekennzeichnet, daß** die Änderung(en) des oder der Parameter(s)(n) durch Vergleich mit gespeicherten Referenzwerten bewertet wird (werden), aufgrund der Werte der Parameter der n-ten Schwingung jeder Signalsequenz des erzeugten periodischen fremderregten Schwingungssignals.

7. Näherungs- oder Anwesenheitsschalteranordnung gemäß einem der Ansprüche 1 bis 5, **dadurch gekennzeichnet, daß** er mindestens einen zweiten Schwingkreis (6) beinhaltet, welchem in identischer Weise das Erregungssignal zugeführt wird, der aber gegen den Einfluß eines elektromagnetische Felder beinflussenden Materials total oder zumindest teilweise abgeschirmt ist, wobei die Bewertung der Änderung(en) mindestens eines Parameters des vom ersten Schwingkreis (2) erzeugten periodischen fremderregten Schwingungssignals, durch Vergleich mit mindestens einem identischen Parameter des vom mindestens zweiten Schwingkreises (6) erzeugten periodischen fremderregten Schwingungssignals, nach Abtasten und gegebenenfalls digitaler Filterung, vorgenommen wird.

8. Näherungs- oder Anwesenheitsschalteranordnung gemäß Anspruch 7, **dadurch gekennzeichnet, daß** die Komponenten (2', 2", 2'''; 6', 6", 6''') und Betriebsmerkmalen der ersten und zweiten Schwingkreise (2 und 6) gleich sind.

9. Näherungs- oder Anwesenheitsschalteranordnung gemäß Anspruch 7 oder 8, **dadurch gekennzeichnet, daß** die Induktivitäten (2' und 6') der beiden Schwingkreise (2 und 6) völlig voneinander entkoppelt sind.

10. Näherungs- oder Anwesenheitsschalteranordnung gemäß Anspruch 7 oder 8, **dadurch gekennzeichnet, daß** die Induktivitäten (2' und 6') der ersten und zweiten Schwingkreise (2 und 6) in einen vorbestimmten Maße miteinander gekoppelt sind.

11. Näherungs- oder Anwesenheitsschalteranordnung gemäß einem der Ansprüche 7 bis 10, soweit sie von Anspruch 3 abhängig sind, **dadurch gekennzeichnet, daß** die Induktivitäten (2' und 6') der ersten und zweiten Schwingkreise (2 und 6) hintereinander im Gehäuse (5), gegenüber der aktiven Fläche (4) desselben, angeordnet sind und, daß zumindest eine Trennwand (7) als elektromagnetischer Schirm zwischen den beiden Induktivitäten (2' und 6')vorgesehen ist.

12. Näherungs- oder Anwesenheitsschalteranordnung gemäß einem der Ansprüche 7 bis 11, **dadurch gekennzeichnet, daß** der Vergleich mindestens eines Parameters der beiden erzeugten periodischen fremderregten Schwingungssignale auf der Basis von abgetasteten Werten vorgenommen wird, wobei die Abtastung mit dem oder auf das Erregungssignal synchronisiert ist.

13. Näherungs- oder Anwesenheitsschalteranordnung gemäß einem der Ansprüche 7 bis 12, **dadurch gekennzeichnet, daß** mindestens ein dritter Schwingkreis vorgesehen ist, welcher in identischer Weise erregt wird und gegenüber einem weiteren aüßeren physikalischem Einfluß zumindest teilweise abgeschirmt ist, und dessen erzeugten periodischen fremderregten Schwingungen als weitere Referenzschwingungen dienen.
